# EUROPEAN PATENT APPLICATION

(11) **EP 2 947 697 A1**
(43) Date of publication of application: **25.11.2015**
(21) Application number: 14003944.7
(22) Date of filing: 24.11.2014
(51) Int. Cl.: H01L 31/0216, H01L 31/055

(54) **Antireflection films and photovoltaic devices**

(30) Priority: 23.12.2013 EP 13006008
(71) Applicant: Merck Patent GmbH, 64293 Darmstadt (DE)
(72) Inventor: Okura, Hiroshi, Hiratsuka-shi, Kanagawa, 254-0821 (JP); Wakimoto, Takeo, Tokyo, 108-0014 (JP); Dertinger, Stephan, Tokyo, 158-0091 (JP); Matsuda, Noriyuki, Chiba-shi, Chiba, 261-0011 (JP); Suzuki, Masayoshi, Tokyo, 151-0062 (JP); Kishimoto, Tadashi, Sagamihara-shi, Kanagawa, 252-0331 (JP)

(57) **Abstract**

The present invention relates to an antireflection film, and to a preparation thereof. The invention further relates to the use of the antireflection film in photovoltaic devices, to a photovoltaic device comprising the antireflection film, to a preparation of a photovoltaic device comprising the antireflection film, and to a preparation of the photovoltaic device comprising the antireflection film.

## Description

### Field of the Invention

The present invention relates to an antireflection film, and to a preparation thereof. The invention further relates to the use of the antireflection film in photovoltaic devices, to a photovoltaic device comprising the antireflection film, and to a preparation of a photovoltaic device comprising the antireflection film.

### Background Art

Photovoltaic devices are commonly used to transfer energy in form of light into electricity. To enhance photoelectron conversion efficiency of photovoltaic devices, several types of optical films are considered to be incorporated into photovoltaic devices.

Several kind of antireflection film, wavelength conversion film, and photovoltaic device with optical film configurations are already described. For example, Japanese patent application laid-open No. H09-230396, Japanese patent application laid-open No. 2000-328053, Japanese patent application laid-open No. 2002-222974, and Japanese patent application laid-open No. 2010- 509175, international patent application laid-open No. WO 2010/023657, Fukuda et. al., "Optical Materials" vol. 32, 2009, p.22 - p.25, and Fujihara et. al., "Journal of Fluorine Chemistry" vol. 130, 2009, p.1106 - p.1110.

### Patent Literature

1. Japanese Patent Application Laid-Open No.H09-230396
2. Japanese Patent Application Laid-Open No. 2000-328053
3. Japanese Patent Application Laid-Open No. 2002-222974
4. Japanese Patent Application Laid-Open No. 2010-509175
5. International publication Number, WO 2010/023657 A2

### Non Patent Literature

6. Fukuda et. al., "Optical Materials" vol. 32, 2009, p.22 - p.25
7. Fujihara et. al., "Journal of Fluorine Chemistry" vol. 130, 2009, p.1106 -p.1110

### Summary of the invention

However, the inventors newly have found that there is still one or more of considerable problems for which improvement is desired, as listed below.
1. An antireflection film having wavelength conversion ability as well as antireflection ability suitable for photovoltaic devices is desired.
2. Simple fabrication process with lower temperature condition for preparing said antireflection film to reduce production cost and / or production step is needed.
3. In addition, photoelectric conversion performance of a photovoltaic device with an optical film is still a need for improvement.

The inventors aimed to solve one or more of the aforementioned problems. Surprisingly, the inventors have found a novel porous antireflection film comprising at least one fluorescent moiety, wherein a matrix material of the porous antireflection film comprises one or more metal oxides.

Preferably, it solves one or more of the problems 1 to 3.

In another aspect, the invention relates to use of the said porous antireflection film in a photovoltaic device, wherein the antireflection film is set on the outermost surface of the light incident side of the photovoltaic module.

The present invention also provides for a method for preparing the said porous antireflection film, wherein the method for preparing the porous antireflection film of the present invention comprises the following sequential steps of
(a) dissolving a precursor solution containing a source of a matrix material of the porous antireflection film, a pore-forming agent and a fluorescent moiety into a solvent;
(b) providing the resulting precursor solution from step (a) over a layer underneath; and
(c) baking the coated precursor solution to provide the porous antireflection film.

In another aspect, the invention further relates to a photovoltaic device (100) comprising:
- the porous antireflection film (110) according to any one of claims 1 to 20; and
- a photovoltaic module (120) embracing a photoactive layer (130).

Furthermore, the present invention provides for a method for preparing the said photovoltaic device (100), wherein the method comprises the step of providing the porous antireflection film onto the outermost surface of the light incident side of the photovoltaic module.

### Description of drawings

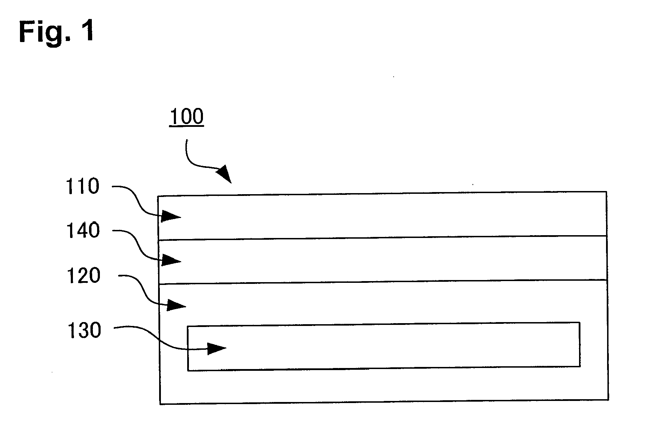

Fig. 1: shows a cross sectional view of a schematic of a photovoltaic device (100) with a porous antireflection film (110).

### Detailed Description of the invention

In a general aspect, a porous antireflection film comprising at least one fluorescent moiety, wherein a matrix material of the porous antireflection film comprises one or more metal oxides.

In a preferred embodiment of the invention the metal oxide is selected from the group consisting of SiO₂, Al₂O₃, TiO₂, and a combination of any of these.

In a preferred embodiment, the average reflective index of the porous antireflection film is in the range from 1.01 to 1.46.

More preferably, from 1.10 to 1.40. Particularly preferably, from 1.20 to 1.35.

According to the present invention the term "average reflective index" means an average reflective index value of the layer overall of the antireflection film measured by UVISEL (Horiba Ltd.) with the condition of an angle of incident light (at 550 nm) is 60 degree.

Preferably, the pores of the porous antireflection film mainly consist of mesoporous. The structure of the pores can be confirmed by Scanning Electron Microscope (SEM).

In a preferred embodiment of the invention, the fluorescent moiety absorbs radiation with a maximum absorption peak wavelength in the range from 250 nm to 450 nm and emits radiation with a maximum emitting peak wavelength in the range from 460 nm to 1000 nm, more preferably, from 500 nm to 900 nm, even more preferably, from 540 nm to 800 nm.

More preferably, the fluorescent moiety is selected from the group consisting of an activator, inorganic fluorescent compound, inorganic fluorescent semiconductor quantum material, organic fluorescent compound, and a combination of any of these.

Preferably, the activator is present and preferably selected from the group consisting of Sc³⁺,Y³⁺, La³⁺, Ce³⁺, Pr³⁺, Nd³⁺, Pm³⁺, Sm³⁺, Eu³⁺, Gd³⁺, Tb³⁺, D^{y3+}, Ho³⁺, Er³⁺, Tm³⁺, Yb³⁺, Lu³⁺, Bi³⁺, Pb²⁺, Mn²⁺, Yb²⁺, Sm²⁺, Eu²⁺, Dy²⁺, Ho²⁺and a combination of any of these.

In a particularly preferred embodiment of the invention, the activator is selected from the group consisting of Ce³⁺, Sm³⁺, Eu³⁺, Tb³⁺, Bi³⁺, Eu²⁺ and a combination of any of these.

In a further preferred embodiment of the invention, the inorganic fluorescent compound is present and preferably selected from the group consisting of sulfides, thiogallates, nitrides, oxynitrides, silicated, aluminates, apatites, borates, oxides, phosphates, halophosphates, sulfates, tungstenates, tantalates, vanadates, molybdates, niobates, titanates, germinates, halides based phosphors, and a combination of any of these.

Suitable inorganic fluorescent materials described above are well known to the skilled person and mentioned e.g. in the phosphor handbook, 2nd edition (CRC Press, 2006), pp. 155 - pp. 338 (W.M.Yen, S.Shionoya and H.Yamamoto), WO2011/147517A, and WO2012/034625A.

More preferably, the inorganic fluorescent compound is selected from the group consisting of YVO₄:Yb³⁺, YVO₄:Eu³⁺, YVO₄: Eu³⁺, Bi³⁺, YVO_{4:}Ce³⁺, Tb³⁺, Y₂O₃:Bi³⁺, Eu³⁺, or Y₂O₃:Ce³⁺, Tb³⁺based phosphors, and a combination of any of these.

In a particularly preferred embodiment of the invention, the said inorganic fluorescent compound has a medium size in the range from 1 nm to 100 nm. More particularly preferably, the medium size is in the range from 3 nm to 50 nm. The most preferably, from 5 nm to 25 nm.

In a further preferred embodiment of the invention, the inorganic fluorescent semiconductor quantum material is present and preferably selected from the group consisting of inorganic fluorescent semiconductor quantum dots, inorganic fluorescent semiconductor quantum rods and a combination of any of these.

For example, for red emission use, CdSe dots, CdSe rods, CdSe dot in CdS rod, ZnSe dot in CdS rod, CdSe/ZnS rods, InP dots, InP rods, CdSe/CdS rods, ZnSe/CdS rods. For green emission use, (CdSe dots, CdSe rods, CdSe/ZnS rods).

Examples of inorganic fluorescent semiconductor quantum dots, inorganic fluorescent semiconductor quantum rods have been described in, for example, the international patent application laid-open No.WO2010/095140.

In another preferred embodiment, an organic fluorescent compound is present and preferably selected from the group consisting of Fluoresceins, Rhodamines, Coumarins, Pyrenes, Cyanines, Perylenes, Di-cyano-methylenes, metal complexes and a combination of any of these.

Suitable organic fluorescent materials described above are well known to the skilled person and mentioned e.g. in the phosphor handbook, 2nd edition (CRC Press, 2006), pp. 769 - pp. 774 (W.M.Yen, S.Shionoya and H.Yamamoto).

In a particularly preferred embodiment of the invention, the organic fluorescent compound is selected from commercially available Coumarin 6 (from Sigma-ALDRICH), DY-707, 730, 732 or 750 (from Funakoshi Ltd.), NK-3590 (from Hayashibara Ltd.), LDS698, 720, 750 or 765 (from Exciton) or a combination of any of these.

Preferably, the internal quantum efficiency of the fluorescent compound and / or the inorganic fluorescent semiconductor quantum material is more than 80 %; more preferably, it is 90 % or more.

The internal quantum efficiency of the fluorescent compounds of the present invention can be measured with an absolute PL (photoluminescence) quantum yield measurement system, such as C9920-02G (Hamamatsu).

In another aspect of the invention, the porous antireflection film comprises a first fluorescent moiety and a second fluorescent moiety, with the first fluorescent moiety being selected from the group consisting of an activator, inorganic fluorescent compound, or inorganic fluorescent semiconductor quantum material, or a combination of any of these; and the second fluorescent moiety being an organic fluorescent compound.

Further particularly preferred is the combination of inorganic fluorescent compounds and organic fluorescent compounds.

In a preferred embodiment of the invention, said organic fluorescent compound absorbs radiation with a maximum absorption peak wavelength in the range from 350 nm to 500 nm more preferably from 375 to 500 nm, even more preferably, from 400 nm to 500 nm and emits radiation with a maximum emitting peak wavelength in the range from approximately 510 nm to approximately 1000 nm, more preferably, from 550 nm to 900 nm, even more preferably, from 600 nm to 800 nm.

Preferably, the emission spectra of the inorganic fluorescent compound and the absorption spectra of the organic compound do overlap.

In a very particularly preferred embodiment of the invention, suitable combinations of inorganic fluorescent compounds and organic compounds are selected from the groups consisting of YVO₄: Bi³⁺, Eu³⁺ and Coumarin 153, YVO₄: Bi³⁺, Eu³⁺ and Lumogen-F570, YVO₄: Bi³⁺, Eu³⁺ and Rhodamine 6G, YVO₄:Ce³⁺, Tb³⁺ and Coumarin 153, YVO₄:Ce³⁺, Tb³⁺ and Lumogen-F570, YVO₄:Ce³⁺, Tb³⁺ and Rhodamine 6G, Y₂O₃:Bi³⁺, Eu³⁺ and Coumarin 153, Y₂O₃:Bi³⁺, Eu³⁺ and Lumogen-F570, Y₂O₃:Bi³⁺, Eu³⁺ and Rhodamine 6G, Y₂O₃:Ce³⁺, Tb³⁺ and Coumarin 153, Y₂O₃:Ce³⁺, Tb³⁺ and Lumogen-F570, Y₂O₃:Ce³⁺, Tb³⁺ and Rhodamine 6G.

In a preferred embodiment of the invention, the reflective index of in the porous antireflection film varies from a low value on the first side of the porous antireflection film to a high value on the second side of the porous antireflection film.

Usually the first side or layer of the film is the upper side or layer, being the outer surface in the final device and the second side or layer of the film is the bottom side, in a final device usually being connected to the surface of a next functional layer or a substrate.

In a further preferred embodiment of the invention, the porous ratio in the porous antireflection film varies from a higher porosity on the first side of the porous antireflection film to lower porosity on the second side of the porous antireflection film.

Particularly preferably, the porous antireflection film consists of two or more stacked layers, and the porous ratio in each stacked layer can be different from each other to form the said porous antireflection film.

More preferred, the porous antireflection film consists of first and second stacked layers, and the first stacked layer has higher porosity than the porosity of the second stacked layer.

The porosity of the antireflection film as well as the porosity of each of the stacked layers, each independently, can be adjusted by controlling the amount of a pore-forming agent used in the manufacturing of the film.

In a further preferred embodiment, the concentration of the fluorescent moiety of the porous antireflection film varies from a lower concentration on the first side of the porous antireflection film to a higher concentration on the second side of the porous antireflection film.

Particularly preferably, the porous antireflection film consists of two or more stacked layers, and the concentration of the fluorescent moiety in each stacked layer can be different from each other to form the said porous antireflection film.

More preferred, the porous antireflection film consists of first and second stacked layers, and the first stacked layer has a lower concentration of the fluorescent moiety than the concentration of the fluorescent moiety in the second stacked layer.

More preferably, the concentration of the fluorescent moiety of the porous antireflection film varies from a lower concentration on the first side of the porous antireflection film to a higher concentration on the second side of the porous antireflection film, where as the porous ratio in the porous antireflection film varies from a higher porosity on the first side of the porous antireflection film to lower porosity on the second side of the porous antireflection film.

Particularly preferably, the porous antireflection film consists of two or more stacked layers. The concentration of the fluorescent moiety and the pore ratio in each stacked layer both can be different from each other to form the said porous antireflection film.

More preferred, the porous antireflection film consists of first and second stacked layers. The first stacked layer has a lower concentration of the fluorescent moiety than the concentration of the fluorescent moiety in the second stacked layer, and the first stacked layer has higher porosity than the porosity of the second stacked layer.

In a further preferred embodiment of the invention, the matrix material used in the second side of the porous antireflection film essentially has higher reflective index than the matrix material used in the first side of the porous antireflection film.

In a preferred embodiment, the porous antireflection film further comprises a photocatalist compound, which preferably is a TiO₂ compound.

The present invention further relates to the use of said antireflection film in a photovoltaic device, where the antireflection film is set on the outermost surface of the light incident side of the photovoltaic module.

In another aspect, the present invention further relates to a photovoltaic device (100) comprising:
- the porous antireflection film (110); and
- a photovoltaic module (120) embracing a photoactive layer (130), where the antireflection film is set on the outermost surface of the light incident side of the photovoltaic module.

As the photovoltaic module, commercially available photovoltaic cells can be used for the purpose of the invention.

Preferably, the photovoltaic device (100) further can include a passivation layer (140) to protect the photovoltaic module (120) between the porous antireflection film (110) and the photovoltaic module (120) as the outermost surface of the light incident side of the photovoltaic module.

In a preferred embodiment of the present invention, the photoactive layer (130) is selected from the groups consisting of amorphous silicon (a-Si), monocrystaline silicon (c-Si), polycrystalline silicon (poly-Si), multicrystaline silicon (mc-Si), microcrystalline silicon (µc-Si), cadmium telluride (CdTe), cupper indium gallium selenide (CIGS), gallium arsenide (GaAs), perovskites or a combination of any of these.

In some embodiments, the antireflection film of the present invention can preferably be prepared by using a liquid -based coating process.

The term "liquid-based coating process" means a process that uses a liquid-based coating composition.

Here, the term "liquid-based coating composition" embraces solutions, dispersions, and suspensions.

More specifically, the liquid-based coating process can be carried out by using at least one of the following processes: solution coating, ink jet printing, spin coating, dip coating, knife coating, bar coating, spray coating, roller coating, slot coating, gravure coating flexographic printing, offset printing, relief printing, intaglio printing, or screen printing.

In general, a source of a matrix material of the porous antireflection film, a pore-forming agent and a fluorescent moiety may together be dissolved in a solvent. Or they may be dissolved separately in the same solvent or in different solvents to obtain separate solutions, which are then mixed. After mixing, the resulting solution is coated over the layer underneath by a liquid coating process as defined herein.

Therefore, the present invention further relates to a method for preparing the said porous antireflection film comprises the following sequential steps of:
(a) dissolving a precursor solution containing a source of a matrix material of the porous antireflection film, a pore-forming agent and a fluorescent moiety into a solvent;
(b) providing the resulting precursor solution from step (a) over a layer underneath; and
(c) baking the coated precursor solution to provide the porous antireflection film.

Preferably, in step (a), mixing is carried out with a mixer. Any suitable type of mixers usually applicable for dispersing can be used. In a further preferred embodiment high speed mixing conditions, with 1,500 rpm or more are applied. The mixing can be done under any suitable atmosphere, but air conditions are sufficient and therefore preferred.

As a preference, in step (b), the resulting solution is coated onto the substrate by a liquid-based coating process. The coating can be applied under air condition. For example a glass substrate can be coated by dipping into the precursor solution.

In a preferred embodiment of the present invention, baking is carried out above 100 °C and under 600 °C, more preferably, above 200 °C and under 500 °C. The applicable atmosphere depends on the chemical nature of the layer material and the fluorescent moiety, but as long as the chemistry doesn't require a specific atmosphere air conditions are preferred. The duration of the baking step depends on the chemistry involved. It need to me long enough that the metal oxide can be formed, but in general can be optimized empirically by comparing the stability, antireflective properties, and intensity of the emission of the resulting layer.

In a preferred embodiment of the present invention, the solvent is a protic solvent. In a further preferred embodiment, the protic solvent is selected from the group consisting of pure water, ethanol, methanol, 1-propanol, 2-propanol, 1-butanol, 2-butanol, 2-metyl-1-propanol, formic acid, HCl, H₂SO₄ or a combination of any of these.

In a preferred embodiment, the pore-forming agent is selected from the group consisting of cationic surfactants, anionic surfactants, non-ionic surfactants, block copolymers, oil based nano droplets, hollow beads, polymer beads and a combination of any of these.

For example, as publically known materials, Polyethyleneglycon tert-octyl phenyl ether (Triton), PMMA polymer beads, methyl methacrylate/acrylic acid copolymer beads, cetyltrimethylammonium bromide as a cationic surfactant, silica hollow beads (such as Q-CEL™ 5020, 5020FPS, 7014, 7040S from Potters-Ballotini Co., Ltd), Polyethylene glycol hexadecyl ether can be used preferably.

Preferably, the polymer beads can be removed by a polymer-extracting solvent, for example, THF (tetrahydrofuran) is suitable for PMMA polymer beads.

Examples of pore-forming agents have been described in, for example, U.S. Patent application laid-open No. 2010/0101649 and European patent application laid-open No. 1329433.

Preferably, the source of a matrix material of the porous antireflection film is a silicon alkoxide, aluminium alkoxide, titanium alkoxide, or a combination of any of these.

More preferably, publically known metal alkoxide materials can be used to form the porous antireflection film as the source of a matrix material.

Such as, tetraethyl orthosilicate (TEOS), methyl triethoxysilane (MTEOS), sodium silicate, lithium silicate, kalium silicate, aluminium isopropoxide, Tripropyl orthoaluminate Al (OC₃H₇)₃ (TPOAI), Aluminum tri-sec-butoxide, Titanium alkoxide, or a combination of any of these. (commercially available, for example from Tokyo Chemical Industry Co., Ltd.)

The working examples 1 - 3 below provide descriptions of the porous antireflection film and photovoltaic devices with the porous antireflection film of the present invention, as well as an in detail description of their fabrication.

In another aspect, the invention further relates to a method for preparing the said photovoltaic device, where the method comprises the step of providing the porous antireflection film onto the outermost surface of the light incident side of the photovoltaic module.

Turning to other components of the photovoltaic module (120) of the present invention, optionally, the photovoltaic module (120) can have a passivation layer (140). Such passivation layers have been found useful for protecting the photoactive layer (130).

Transparent substrates can be used as the passivation layer (140). In general, transparent substrate can be flexible, semi-rigid or rigid.

The material for a transparent substrate is not particularly limited.

Preferably, as a transparent substrate, a transparent polymer substrate, glass substrate, thin glass substrate stacked on a transparent polymer film, transparent metal oxides (for example, oxide silicone, oxide aluminium, oxide titanium), can be used.

A transparent polymer substrate can be made from polyethylene, ethylenevinyl acetate copolymer, ethylene-vinylalcohol copolymer, polypropylene, polystyrene, polymethyl methacrylate, polyvinylchloride, polyvinylalcohol, polyvinylvutyral, nylon, polyether ether ketone, polysulfone, polyether sulfone, tetrafluoroethylene-erfluoroalkylvinyl ether copolymer, polyvinylfluoride, tetraflyoroethylene ethylene copolymer, tetrafluoroethylene hexafluoro polymer copolymer, or a combination of any of these.

In some embodiments, transparent metal oxides, such as alumina, silicone oxide, titanium oxide, water glass (sodium silicate aqueous solution), or transparent polymers, also can be used to form the passivation layer (140).

In some embodiments, the passivation layer (140) can be the wavelength conversion layer.

In general, the methods of preparing each of layers (120), (130), and (140), in the photovoltaic device (100) can vary as desired and selected from well known techniques.

In some embodiments, photovoltaic module (120), photoactive layer (130), or passivation layer (140) can be prepared by a gas phase based coating process (such as Chemical Vapor Deposition, vapor deposition, flash evaporation), or a liquid-based coating process.

In some embodiments, the photovoltaic device (100) and / or the porous antireflection film of the present invention can be prepared in a continuous manufacturing process, such as a roll-to-roll process, thereby significantly reducing the manufacturing cost. Examples of roll-to-roll processes have been described in, for example, U.S. Patents Nos. 7,476,278 and 8,129,616.

### Definition of Terms

According to the present invention, the term "porous antireflection film" is taken to means that shows at least 0.1 or more smaller average reflective index of the layer of the film at 550 nm wavelength of an incident light than a film manufactured in a same manner as the antireflection film of the present invention expect for any pore-forming agents is not used for the fabrication of said film.

In other words, a "porous antireflection film" has a higher porosity in the layer of the film than a film manufactured in a same manner as the antireflection film of the present invention except for any pore-forming agents which is not used.

The Average reflective index of the antireflection film can be measured by a spectroscopic ellipsometer; UVISEL (Horiba Ltd.) with the condition of an angle of incident light is 60 degree.

Porosity of the antireflection film can be measured with a surface area analyzer, Flow Sorb III 2310 (Shimadzu Co.).

The term "mesoporous" means pores with diameters in the range from 2 nm to 50 nm as described in IUPAC notation.

The term "fluorescence" is defined as the physical process of light emission by a substance that has absorbed light or other electromagnetic radiation. It is a form of luminescence. In most cases, the emitted light has a longer wavelength, and therefore lower energy, than the absorbed radiation.

The term "transparent" means at least around 60 % of incident light transmittal at the thickness used in a photovoltaic device and at a wavelength or a range of wavelength used during operation of photovoltaic cells.

Preferably, it is over 70 %, more preferably, over 75%, the most preferably, it is over 80 %.

The term "organic compound" is defined as a substance whose molecules contain one or more carbon atoms covalently bonded with another element or radical including hydrogen, nitrogen, oxygen, the halogens as well as phosphorus, silicon and sulfur.

A few exceptions are carbon monoxide, carbon dioxide, carbonates, cyanides, cyanates, carbides, and thiocyanates, which are considered inorganic.

The term "inorganic compound" means any compound not containing carbon atoms or any compound that containing carbon atoms ionically bound to other atoms such as carbon monoxide, carbon dioxide, carbonates, cyanides, cyanates, carbides, and thiocyanates.

The term "absorption" is defined as the absorbance of a material, which corresponds to the logarithmic ratio of the radiation falling upon a material, to the radiation transmitted through a material.

The term "emission" means the emission of electromagnetic waves by electron transitions in atoms and molecules.

According to the present invention, the term "internal quantum efficiency" is defined as the conversion efficiency of a material from absorbed incident light to luminescence of said material.

The term "microcrystalline silicon (µc-Si)" is taken to mean that has small grains of crystalline silicon within an amorphous phase. Nanocrystalline silicon (nc-Si) is also be embraced by the term "microcrystalline silicon (µc-Si)" according to the present invention.

The term "protic solvent" means a solvent that contains a proton donor. In other words, protic solvents can dissociate by themselves and can donate a proton.

Each feature disclosed in this specification, unless stated otherwise, may be replaced by alternative features serving the same, equivalent, or similar purpose. Thus, unless stated otherwise, each feature disclosed is but one example of a generic series of equivalent or similar features.

The invention is described in more detail in reference to the following examples, which are only illustrative and do not limit the scope of the invention.

### Examples

### Example 1: Fabrication of a porous antireflection film with Eu³⁺ activator

2.6 g of tetraethyl orthosilicate (TEOS), and 1.35 g of HCl (38 wt% in water) were mixed with 1.15 g of Polyethylene glycol hexadecyl ether (from Sigma-Aldrich), in ethanol (5g).

Then, the resulted mixture was stirred at 1,500 rpm at room temperature for 20 minutes in air condition.

After the stirring, 0.144g Eu (CH₃COO)₃ was added to the resulting mixture and it was stirred at 1,500 rpm at room temperature in air condition for 10 minutes to obtain a resulting solution.

A glass substrate was cleaned by sonicating in acetone and isopropanol, respectively. The substrate was then treated with UV/ ozone.

Then, the resulting solution was coated onto the glass substrate by a dipping system at a dipping speed of 0.1 mm/s.

The glass substrate thus formed was dried at 45 ° C for 15 minutes in air condition and further dried at room temperature for 24 hours in air condition. Then, it was annealed at 350 °C for 10 minutes in air condition. Visually, the obtained porous antireflection film was transparent and n value of the film at 633 nm wavelength was 1.32.

### Comparative example 1: Fabrication of a porous antireflection film without Eu³⁺ activator

An antireflection film on the glass substrate as comparative example 1 was made in the same manner as the antireflection film described in Example 1 except for that the Eu(CH₃COO)₃ was not used as the source of activator for the antireflection film.

### Example 2: Fabrication of a porous antireflection film with YVO₄: Bi³⁺, Eu³⁺ phosphor

As a synthesis of YVO₄: Bi³⁺, Eu³⁺ phosphor, a mixture of 0.91 g of sodium oleate (3 mmol) and 0.4 g of Na₃VO₄*12H₂O (1 mmol) in 15 ml of deionized water are gradually stirred into a solution of 2 ml of oleylamine with 8 ml of ethanol.

Then, further stirred for 20 minutes at room temperature in air condition.

A mixture of ethylene glycol and bismuth nitrate pentahydrate as well as a solution of 1 mmol of Y(NO₃)₃ and 0.2 mmol of europium acetate tetrahydrate in 8 ml water were added to this mixture. And the resulting milky mixture was transferred into an autoclave and further stirred for 10 minutes. Then, the autoclave was sealed and heated to 180 °C and further stirred for 12 hours at 180 ° C in air condition.

After cooling of autoclave to room temperature, the resulting white suspension was centrifuged for 10 minutes at 5,000 rpm.

The precipitates were thoroughly washed with ethanol and dried in the air condition at 60 ° C.

Finally, YVO₄: Bi³⁺, Eu³⁺ phosphor was obtained.

Then, the antireflection film on the glass substrate was fabricated in the same manner described in working example 1, except for that the synthesized YVO₄: Bi³⁺, Eu³⁺ phosphor described above was used instead of Eu(CH₃COO)₃.

Visually, the obtained porous antireflection film was transparent and n value of the film at 633 nm wavelength was 1.33.

### Example 3: Fabrication of Tb³⁺ doped porous antireflection film with TiO₂ particle as a photocatalist

2.6 g of Aluminum tri-sec-butoxide, and 1.35 g of HCl (38 wt% in water) were mixed with 1.15 g of Polyethylene glycol hexadecyl ether, in ethanol (5g).

Then, the mixture was stirred at 1,500 rpm at room temperature for 20 minutes in air condition.

After the stirring, Terbium (III) acetate tetrahydrate and AEROXIDE™ P 25 (TiO₂) particle (from AEROSIL) were added to the mixture obtained and further stirred at 1,500 rpm at room temperature for 20 minutes in air condition to obtain a resulting solution.

A glass substrate was cleaned by sonicating in acetone and isopropanol, respectively. The substrate was then treated with UV/ ozone.

Then, the resulting solution was coated onto the glass substrate by a dipping system at a dipping speed of 0.1 mm/s.

The glass substrate thus formed was dried at 45 ° C for 15 minutes in air condition and further dried at room temperature for 24 hours in air condition. Then, it was annealed at 400 °C for 10 minutes in air condition. Visually, the obtained porous antireflection film was transparent and n value of the film at 633 nm wavelength was 1.35.

### Comparative example 2: Fabrication of a porous antireflection film without Tb³⁺ activator or P25 (TiO₂) particle

An antireflection film on the glass substrate as comparative example 2 was made in the same manner as the antireflection film descried in Example 3 except that Terbium (III) acetate tetrahydrate and AEROXIDE™ P 25 (TiO₂) particle were not used.

### Example 4: Fabrication of photovoltaic devices with the antireflection films fabricated in any one of examples 1 to 3

The porous antireflection film obtained in the example 1 was provided onto the outermost surface of the light incident side of a crystal Si solar cell to obtain 1^{st} photovoltaic device.

The porous antireflection films obtained in the example 2-3 were each independently provided onto the outermost surface of the light incident side of the Crystal Si solar cell to obtain 2^{nd} and 3^{rd} photovoltaic devices.

### Comparative example 3: Fabrication of photovoltaic devices with the antireflection films fabricated in any one of comparative examples 1 to 2

The porous antireflection film obtained in the comparative example 1 was provided onto the outermost surface of the light incident side of the crystal Si-solar cell to obtain 1^{st} comparative photovoltaic device.

Further, the porous antireflection film obtained in the comparative example 2 was provided onto the outermost surface of the light incident side of the crystal Si-solar cell to obtain 2^{nd} comparative photovoltaic device.

### Example 5: Evaluation of the photovoltaic devices

The current-voltage characteristics of photovoltaic devices were measured using Keithley 2400 SMU while the photovoltaic devices were exposed to incident light from a Solar Simulator, PEC-L11, Peccell Technologies, Inc. (100 mW/cm²).

Table 1 and Table 2 show the evaluation results.

**Table 1**

| | 1 st phohotovoltaic device | 2nd photovoltaic device | Comparative example 1 |
|---|---|---|---|
| a relative value of short - circuit current | 101.0% | 101.0% | 100.0% |
| a relative value of fill factor | 101.0% | 101.0% | 100.0% |

**Table 2**

| | 3rd pohotovoltaic device | Comparative example 2 |
|---|---|---|
| a relative value of short - circuit current | 100.8% | 100.0% |
| a relative value of fill factor | 100.8% | 100.0% |

### Description of the figures

Fig. 1: shows a cross sectional view of a schematic of a photovoltaic device (100) with a porous antireflection film (110).

### List of reference signs in figure 1

100. a photovoltaic device
110. a porous antireflection film
120. a photovoltaic module
130. a photoactive layer
140. a passivation layer (optional)

## Claims

1. A porous antireflection film (110) comprising at least one fluorescent moiety, wherein a matrix material of the porous antireflection film comprises one or more metal oxides.

2. The porous antireflection film (110) according to claim 1, wherein the metal oxide is selected from the group consisting of SiO₂, Al₂O_{3.} TiO₂, and a combination of any of these.

3. The porous antireflection film (110) according to claim 1 or 2, wherein the average reflective index of the porous antireflection film is in the range from 1.01 to 1.46.

4. The porous antireflection film (110) according to any one or more of claims 1 to 3, wherein the fluorescent moiety absorbs radiation with a maximum absorption peak wavelength in the range from 250 nm to 450 nm and emits radiation with a maximum emitting peak wavelength in the range from 460 nm to 1000 nm.

5. The porous antireflection film (110) according to any one or more of claims 1 to 4, wherein the fluorescent moiety is selected from the group consisting of an activator, inorganic fluorescent compound, inorganic fluorescent semiconductor quantum material, organic fluorescent compound, and a combination of any of these.

6. The porous antireflection film (110) according to claim 5, wherein the activator is selected from the group consisting of Sc³⁺,Y³⁺, La³⁺, Ce³⁺, Pr³⁺, Nd³⁺, Pm³⁺, Sm³⁺, Eu³⁺, Gd³⁺, Tb³⁺, Dy³⁺, Ho³⁺, Er³⁺, Tm³⁺, Yb³⁺, Lu³⁺, Bi³⁺, Pb²⁺, Mn²⁺, Yb²⁺, Sm²⁺, Eu²⁺, Dy²⁺, Ho²⁺ and a combination of any of these.

7. The porous antireflection film (110) according to claim 5 or 6, wherein the inorganic fluorescent compound is selected from the group consisting of sulfides, thiogallates, nitrides, oxynitrides, silicated, aluminates, apatites, borates, oxides, phosphates, halophosphates, sulfates, tungstenates, tantalates, vanadates, molybdates, niobates, titanates, germinates, halides based phosphors, and a combination of any of these.

8. The porous antireflection film (110) according to claim 5 or 7,
wherein the inorganic fluorescent compound has a medium size in the range from 1 nm to 100 nm.

9. The porous antireflection film (110) according to any one or more of claims 1 to 4, wherein the porous antireflection film comprises first fluorescent moiety and second fluorescent moiety with the first fluorescent moiety being selected from the group consisting of an activator, inorganic fluorescent compound, inorganic fluorescent semiconductor quantum material, and a combination of any of these; and the second fluorescent moiety being an organic fluorescent compound.

10. The porous antireflection film (110) according to any one or more of claims 1 to 9,
wherein the reflective index of in the porous antireflection film varies from a low value on the first side of the porous antireflection film to a high value on the second side of the porous antireflection film.

11. The porous antireflection film (110) according to Claim 10, wherein the porous ratio in the porous antireflection film varies from a high porosity on the first side of the porous antireflection film to low porosity on the second side of the porous antireflection film.

12. The porous antireflection film (110) according to claim 10, wherein the concentration of the fluorescent moiety in the porous antireflection film varies from a lower concentration on the first side of the porous antireflection film to a higher concentration on the second side of the porous antireflection film.

13. The porous antireflection film (110) according to claim 10,
wherein the concentration of the fluorescent moiety of porous antireflection film varies from a lower concentration on the first side of the porous antireflection film to a higher concentration on the second side of the porous antireflection film, where as the porous ratio in the porous antireflection film varies from a higher porosity on the first side of the porous antireflection film to lower porosity on the second side of the porous antireflection film.

14. The porous antireflection film (110) according to any one or more of Claims 10 to 13,
wherein the matrix material used in the second side of the porous antireflection film essentially has higher reflective index than the matrix material used in the first side of the porous antireflection film.

15. The porous antireflection film (110) according to any one of Claims 1 to 14,
wherein the porous antireflection film further comprises a photocatalist compound.

16. Use of the porous antireflection film (110) according to any one of claims 1 to 15 in a photovoltaic device, wherein the antireflection film is set on the outermost surface of the light incident side of the photovoltaic module.

17. A photovoltaic device (100) comprising:
• the porous antireflection film (110) according to any one of claims 1 to 15; and
• a photovoltaic module (120) embracing a photoactive layer (130), wherein the antireflection film is set on the outermost surface of the light incident side of the photovoltaic module.

18. Method for preparing the porous antireflection film according to any one of Claims 1 to 15, wherein the method for preparing the porous antireflection film of the present invention comprises the following sequential steps of:
(a) dissolving a precursor solution containing a source of a matrix material of the porous antireflection film, a pore-forming agent and a fluorescent moiety into a solvent;
(b) providing the resulting precursor solution from step (a) over a layer underneath; and
(c) baking the coated precursor solution to provide the porous antireflection film.

19. Method for preparing the porous antireflection film according to Claims 18, wherein the solvent is a protic solvent.

20. Method for preparing the photovoltaic device according to any one of Claims 18 and 19, wherein the method comprises the step of providing the porous antireflection film onto the outermost surface of the light incident side of the photovoltaic module.
